# EUROPÄISCHE PATENTSCHRIFT

(11) **EP 2 465 011 B1**
(45) Veröffentlichungstag und Bekanntmachung des Hinweises auf die Patenterteilung: **23.03.2016**
(21) Anmeldenummer: 10749622.6
(22) Anmeldetag: 06.08.2010
(51) Int. Cl.: G03F 7/20

(54) **VERFAHREN UND VORRICHTUNG ZUM KONSTANTHALTEN DER MASKENABMESSUNGEN**
METHOD AND DEVICE FOR KEEPING MASK DIMENSIONS CONSTANT
PROCÉDÉ ET DISPOSITIF DESTINÉS À MAINTENIR CONSTANTES LES DIMENSIONS DU MASQUE

(30) Priorität: 11.08.2009 DE 102009036953; 12.05.2010 DE 102010020324
(43) Veröffentlichungstag der Anmeldung: 20.06.2012
(73) Patentinhaber: Suss MicroTec Lithography GmbH, 85748 Garching (DE)
(72) Erfinder: ISHII, Takaaki, Yokohama Kanagawa 226-0011 (JP); HÜLSMANN, Thomas, 85748 Garching (DE); HICKMANN, Tobias, 80997 München (DE)
(74) Vertreter: Prinz & Partner mbB
(86) Internationale Anmeldenummer: PCT/EP2010/061479
(87) Internationale Veröffentlichungsnummer: WO 2011/018418

(56) Entgegenhaltungen:
- JP-A- 5 114 541
- JP-A- 2004 039 905
- US-A- 5 604 779
- US-A1- 2004 053 169
- US-B1- 6 455 821

## Beschreibung

Die vorliegende Erfindung betrifft ein Verfahren und eine Vorrichtung zum Konstanthalten der Maskenabmessungen einer Maske bei der Lithografie, z. B. bei Schattenwurfbelichtung, und insbesondere ein Verfahren und eine Vorrichtung, bei denen die Abmessungen der Maske konstant gehalten werden, um eine durch die Maske verursachte, thermisch bedingte Drift der belichteten Stellen auf dem Substrat zu verhindern.

Bei Belichtungsanlagen in der Lithografie ist die Temperatur der einzelnen Elemente einer solchen Vorrichtung ein kritischer Parameter. Vor allem die Temperatur des Substrats und der Maske sollten möglichst konstant sein. Die Änderung der Temperatur in den betreffenden Elementen der Vorrichtung führt zu einer Änderung der Abmessungen der Elemente. Dadurch kann es zu Fehlern bei der Belichtung eines Substrats kommen. Die Temperatur des Substrats kann über den Substratträger gut eingestellt und kontrolliert werden. Es ist wünschenswert, wenn beim Substratwechsel und auch sonst zwischen den einzelnen Belichtungsphasen die Abmessungen der Maske konstant bleiben. Die Belichtung der Substrate heizt die Maske jedoch auf.

Die EP 0 940 718 A2 offenbart eine Luftkühlung zur Kühlung der Maske. Eine Temperaturänderung der Maske aufgrund einer Luftkühlung oder Luftheizung ist jedoch im Normalfall nur langsam möglich. Die Geschwindigkeit, mit der die Temperatur der Maske geändert werden kann, hängt entscheidend von dem Wärmegradienten zwischen Maske und Luft sowie von der Luftführung ab. Je größer der Wärmegradient und je stärker der Luftstrom desto stärker ist auch die Temperaturänderung der Maske. Eine Luftkühlung mit normalen Parametern kann auf die Temperaturveränderung und damit auf die Änderung der Abmessungen der Maske jedoch nicht schnell genug reagieren.

Die US 2004/0053169 A1 beschreibt ein Verfahren zum Minimieren des thermischen Gradienten in einer eUV-Lithografiemaske, die in relativ großem Abstand von dem zu belichtenden Wafer angeordnet ist und durch eine vorderseitig einstrahlende Wärmequelle und eine vom Wafer abgewandte rückseitig kontaktierende Kühlvorrichtung temperiert wird.

Die US 6342941 B1 beschreibt ein Projektionsbelichtungsverfahren, bei dem die Maske vor dem Belichten bis zu einem thermischen Expansions-Sättigungspunkt auf der Basis vorberechneter Daten vorgeheizt wird.

Weiterer Stand der Technik ist aus den US 2003/0179354 A1, US 5593800 A und der DE 2844368 A1 bekannt. US 6,455,821 B1 offenbart ein System und eine Methode mittels lokaler Beheizung eines Retikels um so die Temperaturverteilung im Retikel möglichst gleichmässig zu halten.

Im Hinblick auf die vorstehend erwähnten Probleme des Stands der Technik ist es Aufgabe der vorliegenden Erfindung, ein Verfahren und eine Vorrichtung bereitzustellen, um die Maskenabmessungen vor, während und nach einer Belichtung und insbesondere auch nach einem Substratwechsel konstant zu halten. Eine weitere Aufgabe besteht darin, einen oder mehrere hinreichend schnelle Ausgleichsmechanismen zur Verfügung zustellen, die die möglichen Abmessungsänderungen der Maske aufgrund der Belichtung schnell ausgleichen. Diese und weitere Aufgaben werden durch die Merkmale der Patentansprüche gelöst.

Dabei geht die Erfindung von folgendem Grundgedanken aus: Die Abmessungen einer Maske in der Maskenebene bei der Lithografie eines Substrats werden durch mechanisches Einwirken, d.h. Dehnen oder Stauchen der Maske, während einer Belichtungsphase bzw. einer Nichtbelichtungsphase konstant gehalten.

Die Vorrichtung zum Belichten des Substrats, insbesondere eines Wafers, weist eine Belichtungsquelle, eine Messvorrichtung und eine Heizung und/oder Kühlung auf. Die Maske bildet beim Belichten eine optische Struktur auf dem Substrat ab. Während einer Belichtungsphase wird das Substrat belichtet. Durch die Einwirkung der Belichtungsstrahlung wird die Maske unerwünscht erwärmt. Während einer Nichtbelichtungsphase ist die Belichtung ausgeschaltet. Dadurch kühlt die Maske während der Nichtbelichtungsphase wieder ab. Eine Messvorrichtung misst laufend die Temperatur und/oder die Abmessungen der Maske. Mit einer Heizung kann die Maske während der Nichtbelichtungsphase geheizt werden, damit die Temperatur und damit auch die Abmessungen der Maske konstant bleiben. Alternativ kann das Konstanthalten der Abmessungen der Maske in der Maskenebene auch dadurch erreicht werden, dass die Maske während der Belichtungsphase gekühlt wird.

Eine Maskendehnvorrichtung und/oder Maskenstauchvorrichtung wird verwendet, um die Abmessungen der Maske trotz einer möglichen Temperaturänderung konstant zu halten. Insbesondere wird die Maske dabei während der Nichtbelichtungsphase gedehnt und während der Belichtungsphase gestaucht.

Die Heizung zum Heizen der Maske kann auf unterschiedliche Weise ausgebildet sein. Bevorzugt wird eine Strahlungsheizung verwendet, die im Spektralbereich der Infrarotstrahlung oder der Mikrowellenstrahlung arbeitet. Durch die Strahlung der Strahlungsheizung darf der Fotolack auf dem Substrat jedoch nicht belichtet werden.

Dies kann erreicht werden indem die Strahlung der Strahlungsheizung schräg auf die Maske auftrifft und damit die durch die Maske transmittierte Heizstrahlung am Substrat vorbeigeht.

Die Emission der Strahlungsheizung auf die Maske kann auch senkrecht zur Maskenebene in Richtung auf das Substrat erfolgen. In diesem Fall muss die Strahlung der Strahlungsheizung vollständig in der Maske absorbiert oder im Strahlengang vor dem Substrat durch eine Blende oder einen Shutter blockiert werden, damit der Fotolack auf dem Substrat nicht durch die Strahlungsheizung belichtet wird.

Gemäß einer weiteren Ausführungsform liegt die Wellenlänge der Heizstrahlung außerhalb des Empfindlichkeitsbereichs des Fotolacks und ist z.B. länger als etwa 500 nm. In diesem Fall kann die Strahlung senkrecht zur Maskenebene verlaufen und muss dabei nicht durch einen Shutter geblockt werden.

Es kann auch eine Heizung, die sich in Kontakt mit der Maske befindet, verwendet werden. Der direkte Kontakt führt zu einem guten Wärmeübertrag. Eine Vorrichtung mit einer Lücke zwischen Maske und Heizung ist aufgrund der Wärmeleitung der Luft ebenfalls möglich. Eine Induktionsheizung, mit der elektrisch leitfähige Schichten der Maske geheizt werden können, kann ebenfalls eingesetzt werden. Eine Ultraschallheizung stellt noch eine weitere Möglichkeit dar.

Die Maske kann ebenfalls mit Heizleitern geheizt werden. Die Heizleiter werden entweder direkt auf die Maske oder auf eine Glasplatte aufgebracht, die mit der Maske in thermischen Kontakt gebracht wird. Dabei können mit den Heizleitern mehrere Heizkreise aufgebaut werden, so dass die Maske partiell unterschiedlich geheizt werden kann.

Zu den oben beschriebenen Methoden zum Konstanthalten der Abmessungen der Maske können zusätzlich weitere Methoden einzeln oder in Kombination hinzukommen.

Das Substrat befindet sich während der Belichtungsphasen auf einem Substratträger, über den die Temperatur des Substrats kontrolliert werden kann, wodurch ebenfalls die Abmessungen des Substrats kontrolliert werden können. Ferner kann die Maske, wenn sie beim Kontakt-Belichtungsverfahren mit dem Substrat in Kontakt gebracht wird oder nur knapp oberhalb des Substrats (im Falle des Proximity-Belichtungsverfahrens) angeordnet ist, ihrerseits ebenfalls durch den Substratträger temperiert werden.

In Betriebspausen der Vorrichtung der vorliegenden Erfindung können längere Zeitabschnitte auftreten, in denen sich kein Substrat auf dem Substratträger befindet. In diesen Zeitabschnitten kann der Substratträger direkt mit der Maske in thermischen Kontakt gebracht werden, um die Maske durch direkten Kontakt mit dem Substratträger zu kühlen oder zu heizen.

Die Maske kann durch eine Luftkühlung oder Luftheizung temperiert werden. Die Temperatur der Maske kann auch über einen Maskenhalter geregelt werden. Bevorzugt wird ein Maskenmaterial verwendet, dass nur einen geringen Wärmeausdehnungskoeffizienten aufweist. Elektrisch leitfähige Schichten der Maske können durch Stromfluss in diesen Schichten zum Erwärmen der Maske verwendet werden.

Die Erfindung wird nachstehend mit Bezug auf die Zeichnungen näher erläutert. Dabei zeigen:
Fig. 1 eine schematische Darstellung einer Vorrichtung, bei der die Abmessungen der Maske für die Lithografie mit Hilfe einer Heizung konstant gehalten werden, und
Fig. 2 eine schematische Darstellung einer weiteren Ausführungsform der erfindungsgemäßen Vorrichtung, bei der die Abmessungen der Maske für die Lithografie mit Hilfe einer Vorrichtung zum Dehnen und Stauchen der Maske konstant gehalten werden.

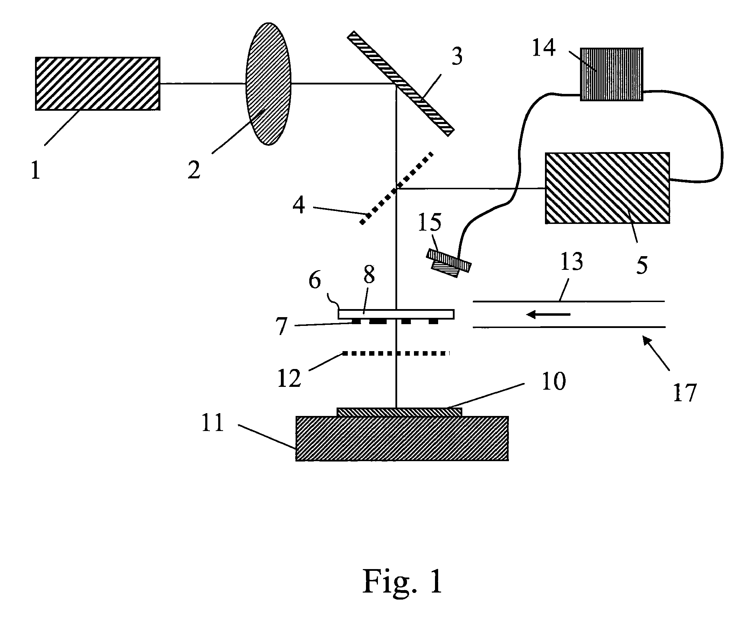

In Fig. 1 wird eine erfindungsgemäße Vorrichtung zum Belichten eines Substrats 10, insbesondere eines Wafers, dargestellt. Die Vorrichtung weist eine Belichtungsquelle 1 auf, deren Emission über ein optisches Abbildungssystem 2 und einen Umlenkspiegel 3 auf eine Maske 6 trifft. Die Maske 6 weist ein für die verwendete Wellenlänge der Lithografie transparentes Trägermaterial 8 und nicht transmittierende Strukturen 7, z.B. aus Chrom, auf. Das Trägermaterial 8 besteht z.B. aus Quarz, Sodalime oder Borsilikat.

Im Falle der Projektionsbelichtung werden die Strukturen 7 durch ein nicht dargestelltes Projektionsobjektiv, das zwischen der Maske 6 und dem Substrat 10 angeordnet ist, auf das Substrat 10 bzw. auf den auf dem Substrat 10 befindlichen (nicht dargestellten) Fotolack abgebildet.

Im Falle der Schattenwurfbelichtung ist ein derartiges Projektionsobjektiv nicht vorgesehen; vielmehr steht die Maske mit dem Substrat in Kontakt (Kontakt-Belichtung) oder ist in geringem Abstand zum Substrat (Proximity-Belichtung), wie dies in Fig. 1 schematisch dargestellt ist.

Das Substrat 10 wird von einem Substratträger 11 gehalten, womit es mit diesem thermisch verbunden ist. Dadurch können die Temperatur und damit die Abmessungen des Substrats 10 über den Substratträger 11 geregelt werden.

Die Abmessungen der Maske 6 oder des Substrats 10 sind kritische Parameter bei der Lithografie. Ändern sich die Abmessungen von einem dieser Elemente oder von beiden Elementen, dann kann es zu Abbildungsfehlern von den Strukturen 7 auf das Substrat 10 kommen. Um dies zu verhindern, müssen die Abmessungen von Maske 6 und Substrat 10 nahezu konstant gehalten werden. Bei dem Substrat 10 gelingt dies sehr gut mit Hilfe der Temperaturregelung des Substratträgers 11. Bei der Lithografie wechseln Belichtungsphasen, bei denen die Emission der Belichtungsquelle 1 auf die Maske 6 strahlt, mit Nichtbelichtungsphasen, bei denen keine Emission von der Belichtungsquelle 1 auf die Maske 6 strahlt. Nichtbelichtungsphasen sind z.B. Zeitabschnitte, in denen das Substrat 10 gewechselt wird. Während einer Belichtungsphase wird die Maske 6 durch die Emission der Belichtungsquelle 1 erwärmt, da ein Teil der Emission der Belichtungsquelle in der Maske 6 absorbiert wird. Während dieser Erwärmung wird sich die Maske 6 ausdehnen. In der anschließenden Nichtbelichtungsphase gibt die Maske 6 Wärme an ihre Umgebung ab. Dadurch verringern sich die Abmessungen der Maske 6 wieder. Insbesondere soll der sogenannte "Runout", d.h. die Änderung der Position der abgebildeten Strukturen auf dem Substrat 10 aufgrund der Erwärmung während aufeinanderfolgender Belichtungszyklen, auf z.B. 0.25 µm begrenzt werden, um die Fehler bei der Lithografie gering zu halten.

Mit der in der Fig. 1 dargestellten Strahlungsheizung 5 können die Abmessungen der Maske 6 nahezu konstant gehalten werden. Dazu werden die Änderungen der Abmessungen der Maske 6 mit einer Messvorrichtung 15 gemessen, und mit einer Steuereinrichtung 14 ausgewertet. Alternativ kann auch die Änderung der Temperatur der Maske 6 gemessen werden. Aus der Änderung der Temperatur werden dann die Änderungen der Abmessungen der Maske 6 mit Hilfe der Steuereinrichtung 14 berechnet. Die Steuereinrichtung 14 regelt die Emission der Strahlungsheizung 5, um die Abmessung über die Belichtungs- und Nichtbelichtungsphasen hinweg konstant zu halten.

Die Strahlung der Strahlungsheizung kann über einen Umlenkspiegel 4 senkrecht auf die Maske 6 geleitet werden. Befindet sich der Umlenkspiegel 4 im Strahlengang der Belichtungsquelle 1, dann muss der Umlenkspiegel 4 bei jeder Belichtungsphase aus dem Strahlengang gefahren werden. Alternativ ist der Umlenkspiegel 4 bei der Wellenlänge der Belichtungsquelle 1, z.B. im UV-Bereich, transparent und im Wellenlängenbereich der Strahlungsheizung 5, z.B. im IR-Bereich oder im Mikrowellenbereich, reflektierend. Absorbiert die Maske 6 die Emission der Strahlungsheizung 5 nicht vollständig, dann ist vorzugsweise im Strahlengang zwischen Maske 6 und Substrat 10 eine Blende oder Shutter 12 vorgesehen, der den durch die Maske 6 transmittierten Anteil der Emission der Strahlungsheizung 5 während der Betriebsphase der Strahlungsheizung 5 unterbricht, damit dieser Emissionsanteil nicht bzw. möglichst wenig auf den auf dem Substrat 10 befindlichen (nicht dargestellten) Fotolack einwirkt.

Alternativ kann die Strahlungsheizung auch ohne Umlenkspiegel verwendet werden. In diesem Fall wird die Strahlungsheizung während der Nichtbelichtungsphase selbst in den Strahlengang geschwenkt und aktiviert.

Durch die Strahlungsheizung 5 wird die Temperatur der Maske 6 konstantgehalten. Dazu kann, wie oben beschrieben, die Emission der Strahlungsheizung 5 mit Hilfe einer Messvorrichtung 15 und einer Steuereinrichtung 14 geregelt werden. Alternativ kann die absorbierte Leistung der Emission der Strahlungsheizung 5 in der Maske 6 an die absorbierte Leistung der Emission der Belichtungsquelle 1 in der Maske 6 einmal angeglichen werden. Die Strahlungsheizung 5 emittiert dann während der Nichtbelichtungsphasen kontinuierlich mit dieser ermittelten Leistung, um die Temperatur der Maske 6 während der Nichtbelichtungsphase möglichst auf dem gleichen Temperaturwert wie während der Belichtungsphase, also möglichst konstant zu halten.

Wie in Fig. 1 dargestellt, kann zusätzlich eine Luftheizung bzw. Luftkühlung 17 verwendet werden. Hierzu wird die Maske 6, z.B. über ein Rohr 13, mit einem warmen oder kalten Gas umspült. Da eine Luftheizung und eine Luftkühlung 17 die Temperatur der Maske 6 in der Regel nur relativ langsam verändern, werden sie bevorzugt eingesetzt, um langsam veränderliche Temperaturschwankungen der Maske 6 auszugleichen.

Alternativ zu der in Fig. 1 dargestellten Ausführungsform der vorliegenden Erfindung kann sich die Maske 6 auch in direktem Kontakt mit dem Substrat 10 befinden. Die Strukturen 7 der Maske werden direkt auf das Substrat abgebildet. Maske 6 und Substrat 10 stehen dann in thermischen Kontakt miteinander. Dadurch können die Temperatur der Maske 6 und damit auch die Abmessungen der Maske 6 zusätzlich durch den Substratträger 11 geregelt werden.

Die Abmessungen der Maske 6 können auch in anderer Weise konstant gehalten werden, z.B. durch Heizen mittels Ultraschall, Heizen durch Induktion bzw. Heizen durch Stromfluss, falls die Maske 6 elektrisch leitfähige Schichten aufweist, und Heizen durch eine Kontakt- oder Fast-Kontaktheizung. Bei einer Medienheizung wird die Maske 6 zum Kühlen oder Heizen von einem Gas oder einer Flüssigkeit umströmt.

Bei einer speziellen Ausführung einer Kontaktheizung werden Heizleiter auf die Maske 6 aufgedampft oder anderweitig aufgebracht. Mit Hilfe ebenfalls aufgedampfter oder anderweitig auf die Maske 6 aufgebrachter Sensoren kann die an die Maske 6 abgegebene Heizenergie geregelt werden, um die Maskentemperatur konstant zu halten. Im Fall der Belichtung der Maske 6 wird die Abgabe der Heizenergie durch die Heizleiter an die Maske 6 reduziert bzw. gestoppt. Dabei müssen die aufgebrachten Schichten ausreichend UV-durchlässig sein und dürfen das für die Lithografie verwendete Licht nicht streuen.

Aus Kostengründen wird die Maske 6 bevorzugt nicht verändert. In diesem Fall können die Heizleiter und die Temperatursensoren auf eine Glasplatte aufgedampft oder anderweitig aufgebracht werden. Die Glasplatte wird dann mit der Maske 6 in thermischen Kontakt gebracht.

Mit den Heizleitern können mehrere separate Heizkreise aufgebaut werden. Das hat den Vorteil, dass die Maske 6 partiell unterschiedlich beheizt werden kann. Damit kann eine noch bessere Anpassung der Maske für ein optimales Lithografieergebnis erreicht werden.

Alternativ oder zusätzlich zum Heizen der Maske 6 in der Nichtbelichtungsphase kann die Maske 6 in der Belichtungsphase gekühlt werden. Dabei wird die Kühleinrichtung bevorzugt mit der Maske 6 in Kontakt gebracht, um einen guten Wärmeübertrag zu gewährleisten.

Das Aufheizen der Maske 6 durch Absorption der Strahlungsenergie der Belichtungsquelle 1 erzeugt nicht nur eine Änderung der Abmessungen der Maske sondern im allgemeinen auch einen zusätzlichen Justierfehler. Der zusätzliche Justierfehler wird dadurch verursacht, dass die Wärmeausdehnung im allgemeinen nicht von der Mitte der Maske 6 ausgeht, da der Fixpunkt der Ausdehnung der Maske 6 irgendwo zufällig im Bereich der Maske 6 an einer Stelle liegt, an der die Maske (z.B. durch eine durch Vakuum betätigte Saughalterung) gehalten wird. Durch die erfindungsgemäßen Maßnahmen zum Konstanthalten der Maskenabmessungen während der Belichtungs- und Nichtbelichtungsphasen kann auch dieser zusätzliche Justierfehler vermieden werden.

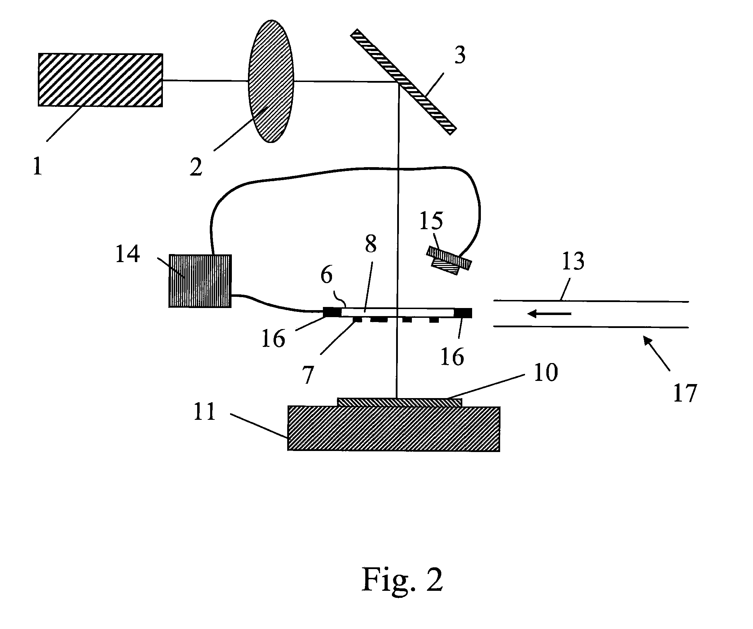

Fig. 2 zeigt eine Ausführungsform der vorliegenden Erfindung. Aufgrund der großen Ähnlichkeit zu der in Fig. 1 dargestellten Ausführungsform wird an dieser Stelle nur noch auf die Unterschiede der Ausführungsformen eingegangen. Gemäß Fig. 2 befindet sich am Rand um die Maske 6 herum, z.B. in Form eines variablen Rahmens, eine in der Maskenebene wirkende Maskendehnvorrichtung 16 und/oder Maskenstauchvorrichtung 16. Damit kann die Maske 6 z. B. bei Temperaturänderungen in der Maskenebene gedehnt bzw. gestaucht werden, damit die Maskenabmessungen konstant gehalten werden. Die Maskendehn- bzw. Maskenstauchvorrichtung 16 wird über die Steuereinrichtung 14 geregelt. Die Maskendehn- und/oder Maskenstauchvorrichtung 16 kann mit allen oben beschriebenen Methoden zum Konstanthalten der Maskenabmessungen kombiniert werden.

## Patentansprüche

1. Verfahren zum Konstanthalten der Abmessungen einer Maske (6) in der Maskenebene bei der Lithografie, z. B. der Schattenwurf-Lithografie eines Substrats (10), insbesondere eines Wafers, mit den Schritten:
a) Belichten der Maske (6) mit einer Belichtungsquelle (1) während einer Belichtungsphase und
b) Nichtbelichten der Maske (6) während einer Nichtbelichtungsphase,
c) wobei während der Schritte a) und b) die Temperatur und/oder die Abmessungen der Maske (6) gemessen werden und
d) wobei die Maske (6) zum Konstanthalten der Maskenabmessungen in Schritt a) oder/und in Schritt b) mechanisch gestaucht oder gedehnt wird.

2. Verfahren nach Anspruch 1,
wobei die Maske (6) zum Konstanthalten der Maskentemperatur in Schritt b) beheizt und/oder in Schritt a) gekühlt wird.

3. Verfahren nach Anspruch 1, wobei die Maske (6) zum Konstanthalten der Maskentemperatur in Schritt b) beheizt und/oder in Schritt a)gekühlt wird, und zwar (i) durch direkten Kontakt der Maske (6) mit einem Substratträger (11) oder (ii) durch direkten Kontakt der Maske (6) mit dem Substrat (10) auf dem Substratträger (11) oder (iii) durch Wärmeübertrag bei geringem Abstand zwischen Maske (6) und dem Substrat (10) bzw. dem Substratträger (11).

4. Verfahren nach einem der Ansprüche 1 bis 3, wobei die Maske (6) ein Material mit geringer Wärmeausdehnung aufweist.

5. Verfahren nach einem der Ansprüche 1 bis 4, mit einem Substratträger (11) zum Halten und Temperieren des Substrats (10).

6. Verfahren nach einem der Ansprüche 1 bis 5, mit auf der Maske (6) aufgebrachten Heizleitern.

7. Verfahren nach einem der Ansprüche 1 bis 6, mit einer mit der Maske (6) in thermischem Kontakt stehenden Heizleiter aufweisenden Glasplatte.

8. Verfahren nach Anspruch 2, 3 oder 7, mit mehreren separaten Heizkreisen aus Heizleitern zum partiellen und selektiven und/oder unterschiedlichen Heizen der Maske (6).

9. Verfahren nach einem der Ansprüche 1 bis 8, wobei die Heizung (5) eine Kontakt-, Fast-Kontakt-, Medien-, Induktions-, Ultraschall- oder Strahlungsheizung aufweist.

10. Verfahren nach Anspruch 9, wobei die Strahlungsheizung (5) im Wellenlängenbereich der Infrarot- oder der Mikrowellenstrahlung arbeitet.

11. Verfahren nach einem der Ansprüche 1 bis 10, wobei die Maske (6) elektrisch leitfähige Schichten zum Heizen der Maske durch Stromfluss durch die Maske (6) aufweist.

12. Verfahren nach einem der Ansprüche 1 bis 11, mit einem Shutter (12) im Strahlengang zwischen der Maske (6) und dem Substrat (10) zum selektiven Blockieren der Strahlung der Strahlungsheizung (5).

13. Vorrichtung zum Belichten, insbesondere Schattenwurf-Belichten eines Substrats (10), insbesondere eines Wafers, mit:
a) einer Belichtungsquelle (1),
b) einer Maske (6) zum optischen Abbilden einer Struktur auf dem Substrat (10),
c) einer Messvorrichtung (15) zum Messen der Temperatur und/oder der Abmessungen der Maske (6), und
d) einer mechanischen Maskendehnvorrichtung (16) und/oder mechanischen Maskenstauchvorrichtung (16) zum Konstanthalten der Abmessungen der Maske (6).

14. Vorrichtung nach Anspruch 13 zum Konstanthalten der Abmessungen der Maske (6) mit einer Heizung (5) und/oder Kühlung zum Konstanthalten der Temperatur der Maske (6).

15. Vorrichtung nach einem der Ansprüche 13 oder 14, mit einer Einrichtung zum Temperieren der Maske (6) durch thermischen Kontakt von Substratträger (11) und Substrat (10) und thermischem Kontakt oder geringem Abstand zwischen Substrat (10) und Maske (6) während der Lithografie.

16. Vorrichtung nach einem der Ansprüche 13 bis 15, mit einer Einrichtung zum Kühlen oder Heizen der Maske (6) ohne Substrat (10) während der Betriebspausen durch direkten Kontakt zwischen Substratträger (11) und Maske (6).

17. Vorrichtung nach einem der Ansprüche 13 bis 16, mit einem Maskenhalter zum Temperieren der Maske (6).

18. Vorrichtung nach einem der Ansprüche 13 bis 17, mit einer Luftkühlung (17) und/oder Luftheizung (17) zum zusätzlichen Temperieren der Maske (6).

19. Vorrichtung nach einem der Ansprüche 13 bis 18, mit einem Substratträger (11) zum Halten und Temperieren des Substrats (10).

## Claims

1. A method of keeping the dimensions of a mask (6) constant in the mask plane in lithography, e.g. in the shadow casting lithography of a substrate (10), in particular a wafer, comprising the steps of:
(a) exposing the mask (6) by means of an exposure source (1) during an exposure phase, and
(b) non-exposing the mask (6) during a non-exposure phase,
(c) wherein during steps (a) and (b), the temperature and/or the dimensions of the mask (6) are measured, and
(d) wherein the mask (6) is mechanically compressed or expanded in step (a) and/or in step (b) to keep the mask dimensions constant.

2. The method according to claim 1,
wherein the mask (6) is heated in step (b) and/or cooled in step (a) to keep the mask temperature constant.

3. The method according to claim 1, wherein the mask (6) is heated in step (b) and/or cooled in step (a) to keep the mask temperature constant, more specifically (i) by direct contact of the mask (6) with a substrate support (11) or (ii) by direct contact of the mask (6) with the substrate (10) on the substrate support (11) or (iii) by heat transfer at a small distance between the mask (6) and the substrate (10) or the substrate support (11).

4. The method according to any of claims 1 to 3, wherein the mask (6) includes a material having a low thermal expansion.

5. The method according to any of claims 1 to 4, comprising a substrate support (11) for holding and for controlling the temperature of the substrate (10).

6. The method according to any of claims 1 to 5, comprising heating conductors applied to the mask (6).

7. The method according to any of claims 1 to 6, comprising a glass plate including heating conductors which are in thermal contact with the mask (6).

8. The method according to claim 2, 3 or 7, comprising a plurality of separate heating circuits made up of heating conductors for partially and selectively and/or differently heating the mask (6).

9. The method according to any of claims 1 to 8, wherein the heater (5) includes a contact, almost-contact, medium, induction, ultrasonic or radiant heater.

10. The method according to claim 9, wherein the radiant heater (5) operates in the wavelength range of the infrared or microwave radiation.

11. The method according to any of claims 1 to 10, wherein the mask (6) includes electrically conductive layers for heating the mask by a current flow through the mask (6).

12. The method according to any of claims 1 to 11, comprising a shutter (12) in the beam path between the mask (6) and the substrate (10) for selectively blocking the radiation of the radiant heater (5).

13. A device for exposing, in particular shadow casting exposing, a substrate (10), in particular a wafer, comprising:
(a) an exposure source (1),
(b) a mask (6) for optically forming an image of a structure on the substrate (10),
(c) a measuring device (15) for measuring the temperature and/or the dimensions of the mask (6), and
(d) a mechanical mask expansion device (16) and/or a mechanical mask compression device (16) for keeping the dimensions of the mask (6) constant.

14. The device according to claim 13 for keeping the dimensions of the mask (6) constant, comprising a heater (5) and/or a cooler for keeping the temperature of the mask (6) constant.

15. The device according to either of claims 13 or 14, comprising a means for controlling the temperature of the mask (6) by thermal contact of the substrate support (11) and the substrate (10) and thermal contact or a small distance between the substrate (10) and the mask (6) during lithography.

16. The device according to any of claims 13 to 15, comprising a means for cooling or heating the mask (6) without the substrate (10) during the pauses in operation by direct contact between the substrate support (11) and the mask (6).

17. The device according to any of claims 13 to 16, comprising a mask holder for controlling the temperature of the mask (6).

18. The device according to any of claims 13 to 17, comprising an air cooler (17) and/or an air heater (17) for additionally controlling the temperature of the mask (6).

19. The device according to any of claims 13 to 18, comprising a substrate support (11) for holding and for controlling the temperature of the substrate (10).

## Revendications

1. Procédé pour maintenir constantes les dimensions d'un masque (6) dans le plan de masque dans la lithographie, par exemple dans la lithographie par projection d'ombre d'un substrat (10), en particulier d'un wafer, comprenant les étapes dans lesquelles :
a) le masque (6) est exposé au moyen d'une source d'exposition (1) pendant une phase d'exposition, et
b) le masque (6) n'est pas exposé pendant une phase de non-exposition,
c) la température et/ou les dimensions du masque (6) étant mesurées lors des étapes a) et b), et
d) le masque (6) étant mécaniquement comprimé ou allongé à l'étape a) et/ou à l'étape b) pour maintenir les dimensions de masque constantes.

2. Procédé selon la revendication 1,
le masque (6) étant chauffé à l'étape b) et/ou refroidi à l'étape a) pour maintenir la température de masque constante.

3. Procédé selon la revendication 1, le masque (6) étant chauffé à l'étape b) et/ou refroidi à l'étape a) pour maintenir la température de masque constante, plus précisément (i) par contact direct du masque (6) avec un support de substrat (11) ou (ii) par contact direct du masque (6) avec le substrat (10) sur le support de substrat (11) ou (iii) par transfert de chaleur à faible distance entre le masque (6) et le substrat (10) ou le support de substrat (11).

4. Procédé selon l'une des revendications 1 à 3, le masque (6) présentant une matière à faible dilatation thermique.

5. Procédé selon l'une des revendications 1 à 4, comportant un support de substrat (11) pour retenir le substrat (10) et équilibrer la température de celui-ci.

6. Procédé selon l'une des revendications 1 à 5, comportant des conducteurs chauffants appliqués sur le masque (6).

7. Procédé selon l'une des revendications 1 à 6, comportant une plaque de verre qui présente des conducteurs chauffants en contact thermique avec le masque (6).

8. Procédé selon la revendication 2, 3 ou 7, comportant une pluralité de circuits de chauffage séparés composés de conducteurs chauffants pour chauffer le masque (6) partiellement et sélectivement et/ou différemment.

9. Procédé selon l'une des revendications 1 à 8, le chauffage (5) présentant un chauffage par contact, par presque-contact, par agent, à induction, ultrasonore ou par rayonnement.

10. Procédé selon la revendication 9, le chauffage par rayonnement (5) fonctionnant dans la plage de longueur d'onde du rayonnement infrarouge ou microonde.

11. Procédé selon l'une des revendications 1 à 10, le masque (6) présentant des couches électriquement conductrices pour le chauffage du masque au moyen d'un flux de courant à travers le masque (6).

12. Procédé selon l'une des revendications 1 à 11, comportant un obturateur (12) dans la trajectoire des rayons entre le masque (6) et le substrat (10) pour le blocage sélectif du rayonnement du chauffage par rayonnement (5).

13. Dispositif pour l'exposition, en particulier pour l'exposition par projection d'ombre d'un substrat (10), en particulier d'un wafer, comportant :
a) une source d'exposition (1),
b) un masque (6) pour la représentation optique d'une structure sur le substrat (10),
c) un dispositif de mesure (15) pour mesurer la température et/ou les dimensions du masque (6), et
d) un dispositif d'allongement de masque mécanique (16) et/ou un dispositif de compression de masque mécanique (16) pour maintenir constantes les dimensions du masque (6).

14. Dispositif selon la revendication 13 pour maintenir constantes les dimensions du masque (6) au moyen d'un chauffage (5) et/ou d'un refroidisseur pour maintenir la température du masque (6) constante.

15. Dispositif selon l'une des revendications 13 ou 14, comportant un moyen pour équilibrer la température du masque (6) par contact thermique du support de substrat (11) et du substrat (10) et par contact thermique ou par faible distance entre le substrat (10) et le masque (6) pendant la lithographie.

16. Dispositif selon l'une des revendications 13 à 15, comportant un moyen pour refroidir ou chauffer le masque (6) sans substrat (10) pendant les pauses de fonctionnement par un contact direct entre le support de substrat (11) et le masque (6).

17. Dispositif selon l'une des revendications 13 à 16, comportant un porte-masque pour équilibrer la température du masque (6).

18. Dispositif selon l'une des revendications 13 à 17, comportant un refroidisseur d'air (17) et/ou un chauffage d'air (17) pour un équilibrage additionnel de la température du masque (6).

19. Dispositif selon l'une des revendications 13 à 18, comportant un support de substrat (11) pour retenir le substrat (10) et équilibrer la température de celui-ci.
